# EUROPEAN PATENT APPLICATION

(11) **EP 1 202 146 A1**
(43) Date of publication of application: **02.05.2002**
(21) Application number: 00309321.8
(22) Date of filing: 23.10.2000
(51) Int. Cl.: G05B 23/02

(54) **System for controlling electrical parameters of circuit components**

(71) Applicant: LUCENT TECHNOLOGIES INC., Murray Hill, New Jersey 07974-0636 (US)
(72) Inventor: Dietsche, Stefan Axel, Nürnberg 90491 (DE)
(74) Representative: Williams, David John

(57) **Abstract**

The invention relates to a system for controlling electrical parameters of circuit components in electrical and/or electronic apparatuses, said system being used to eliminate essentially all manual tuning operations and to optimize and automate the tuning operations such that they can also be carried out under real conditions, in particular, and also to a computer program suitable for controlling such a system.

To this end, the invention provides a system which comprises at least one device (1a, 1b, 1c, 1d, 4), respectively allocated to each parameter which is to be controlled, for measuring the parameter and at least one device (8a, 8b, 8c), respectively allocated to each parameter which is to be controlled, for supplying a controlled variable, the at least one measuring device (1a, 1b, 1c, 1d, 4) and device (8a, 8b, 8c) for supplying the controlled variable being connected via a common bus (6) to a control device (9) which drives the associated device (8a, 8b, 8c) for supplying the controlled variable on the basis of a measured parameter.

## Description

The invention relates to a system for controlling electrical parameters of circuit components in electrical and/or electronic apparatuses, and also to a computer program suitable for controlling such a system.

In essentially all technical areas of use, electrical and/or electronic apparatuses conventionally contain electrical parameters which need to be appropriately tuned or set in order to be able to obtain the desired electrical properties of the apparatus. An example which may be cited at this point is impedance matching in radio-frequency power amplifiers.

The more complex the design of such an electrical and/or electronic apparatus, for example a transceiver unit in a mobile radio system, the greater in general the number of circuit parts whose parameters need to be individually tuned.

To this end, conventionally, the respective parameter to be set is first measured and set manually using a potentiometer or a resistor decade. A citable disadvantage of this is, in particular, the sometimes extremely long operation time which, in turn, has a cost-intensive effect on the production of such apparatuses. Consequently, finding, checking and/or individually tuning faulty circuit components when faults occur, particularly when there are a multiplicity of electrical parameters, are often very laborious and, furthermore, cannot generally be done directly at the site at which the apparatus is used.

European Patent Application EP-A-0 609 053 discloses a voltage-controlled integrated circuit for setting the operating voltage of a radio-frequency component. In this case, changes in the voltage level of the radio-frequency device are detected by a reference diode and are corrected appropriately by electronic means using a control input voltage. A computer connected to the control input voltage via a digital/analogue converter permits fine voltage setting in this case.

However, this patent application does not reveal any disclosure going beyond the description of the electronic actuator as such for setting the operating voltage of a component.

Hence, the object of the invention is to show a way of eliminating essentially all manual tuning operations and of optimizing and automating the tuning operations such that they can also be carried out in particular under real conditions.

The object is surprisingly already achieved according to the invention by a system having the characterizing features of Claim 1 and also by a computer program having the characterizing features of Claim 10.

Advantageous and/or preferred embodiments and developments of the invention are dealt with in the dependent claims.

Hence, the invention provides a system for controlling electrical parameters of circuit components in electrical and/or electronic apparatuses, the system comprising at least one device, respectively allocated to each parameter which is to be controlled, for measuring the parameter and at least one device, respectively allocated to each parameter which is to be controlled, for supplying a controlled variable, and the at least one measuring device and at least one device for supplying the controlled variable being connected via a common bus to a control device which drives the associated device for supplying the controlled variable on the basis of a measured parameter.

Providing a bus as interface between the respective measurement and setting branches, on the one hand, and a control device which controls the supply of an appropriate controlled variable on the basis of a respectively measured parameter value makes it possible to carry out essentially all tuning operations, for example within a housing which is impervious to radio frequency, under extreme temperature conditions and/or within an entire electrical and/or electronic apparatus. In addition, it also permits automated checking and/or the automated retuning of individual parameters or of a plurality of parameters, for example as a result of drift owing to aging and/or extreme operating conditions, even in the field. Furthermore, the use of a common bus significantly reduces the technical complexity by comparison with a multiplicity of local control and/or regulating circuits.

One preferred development provides for the control device to be in the form of a programmable processor device, so that, in particular, additional test routines can be implemented, in order, for example, for an alarm to be triggered in the event of a fault. A particular advantage of this is that such test routines can be used to localize a faulty circuit part quickly, and the check and possibly the retuning operation in the field are made much easier.

Expediently, the control device carries out a comparison between the respective measured parameter and a prescribable nominal value, so that, in practice, the existing electrical and/or electronic apparatus may also be used for other applications, for example by simply changing one or more nominal values. Such a change in the nominal value assignment is also advantageous when one component needs to be replaced by another component, which, for example, requires a different no-load current or a different operating voltage, or which has a different gain.

Expediently, provision is also made for the measured parameter to be mapped onto a digital measured value by means of an A/D converter, the device for supplying the controlled variable in this case comprising a D/A converter whose output variable is used as controlled variable for the parameter which is to be set. This permits, in particular, the tuning operations to be carried out much more accurately than previously, because there is no longer any tie to a series of resistance standards, for example, and intermediate values are accessible.

The invention also proposes that the measuring device and/or the supplying device be allocated a buffer memory (buffer) which can be used to freeze the bit sequence present at the output of the A/D converter and at the input of the D/A converter, so that said bit sequence can be maintained in the buffer even after the operating voltage has been interrupted, depending on the configuration and specific application area.

In a further advantageous embodiment, the invention provides for the bus arranged as interface between the measurement and setting branches and the control device to be in a freely configurable form, so that the system according to the invention can be expanded on an application-specific basis. Thus, in particular, provision is made for at least one memory device connected to the bus to be, in particular, in the form of an EEPROM in which, in particular, selected aforementioned bit sequences can be stored in order to be copied into the buffer when the system is restarted. In this context, the order of the copying processes is preferably controlled by the processor. Furthermore, a computer program which jointly determines the measurement and/or tuning processes can be stored in the memory and/or can be replaced by other measurement and/or tuning routines if required.

One practical embodiment also provides an external memory which can be connected to the bus via an interface and in which selected control parameters can also be stored locally.

The system according to the invention can thus carry out [lacuna], particularly using the freely configurable bus, to check and tune different parameters for largely standardized program software.

Depending on the application area, provision is also made for the system according to the invention to be in the form of an integrated circuit.

The invention is described in detail below with the aid of an illustrative embodiment with reference to the appended drawing, in which:

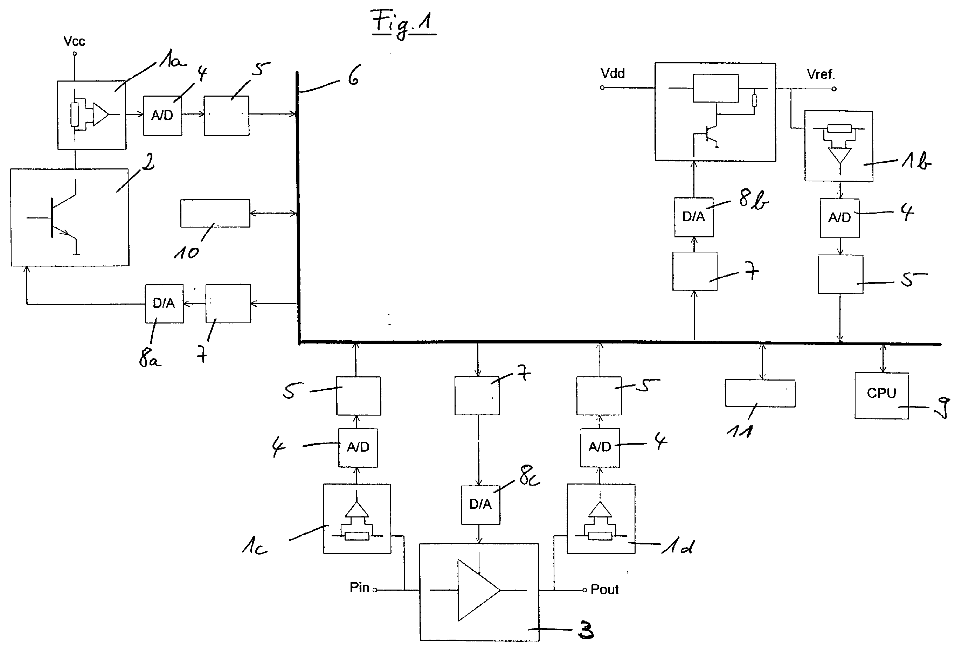

- Figure 1: shows a detail of a schematic block diagram of an inventive embodiment of a system for controlling electrical parameters.

Figure 1 shows by way of example, as a possible application instance of the invention, a sketched partial detail of an inventive system implemented in a transceiver in a base station in a mobile radio system.

The control system shown has a circuit arrangement 1a for measuring the no-load current of a transistor 2, a circuit arrangement 1b for measuring a reference voltage V_{ref}, and also two circuit arrangements 1c and 1d for detecting the input power and output power of an operational amplifier 3 in order to detect the gain factor thereof. The measuring circuits 1a, 1b, 1c and 1d are each connected to a common bus 6 via an A/D converter 4 and a downstream-connected buffer memory 5, called "buffer" below. In addition, from the common bus 6 there extend control branches for supplying an appropriate controlled variable for the respective parameter to be controlled. To this end, the control branches first comprise a respective buffer 7, connected to the common bus 6, and a D/A converter 8a, 8b or 8c which is connected downstream in each case and whose output is connected to the respective circuit part, in a manner which is known per se to the person skilled in the art in this field, such that the output variable from the respective D/A converter 8a, 8b or 8c can be used as controlled variable for the respective parameter to be controlled. In other words, the output signals produced at each of the outputs of the D/A converters 8a, 8b and 8c are used to set or correct the parameters detected previously by means of the circuits 1a, 1b and 1c and ld.

Also connected to the common bus 6 are a programmable microprocessor 9, a memory 10 and an interface 11, the interface 11 usefully being in the form of a radio interface.

The essential way in which the control system according to the invention works is described below.

The respective electrical parameters to be tuned or monitored and possibly corrected, that is to say the no-load current of the transistor 2, the reference voltage V_{ref} and the gain factor of the operational amplifier 3 in the present illustrative case, are measured in analogue form directly or indirectly by means of the respective measuring circuits 1a, 1b and 1c and 1d, which are connected appropriately for this purpose, and are then mapped onto a digital measured value using the respective A/D converter 4 connected downstream. These digital measured values are transferred to the common bus 6 and are read out by the microprocessor 9. The microprocessor 9 then compares the digital measured values with a respectively prescribed nominal value and, in the event of discrepancies between the measured actual value and the prescribed nominal value, drives the appropriate D/A converter 8a, 8b and/or 8c via the common bus 6, the respective output variables of said D/A converter being used as controlled variables for the respective parameter to be set. The respective nominal values and/or a computer program controlling the measurement and possibly tuning processes can be stored, as required, in the memory 10 connected to the bus 6 and/or can be loaded externally via the interface 11 provided.

The respective parameters measured and mapped onto a digital measured value can additionally be temporarily stored in the respective buffers 5 connected downstream of the A/D converters 4, so that, depending on circuit configuration, individual, preferably selectable bit sequences can be maintained in the buffers 5, for example even after the operating voltage has been interrupted. The same happens with the respective bit sequences applied to the input of the D/A converters 8a, 8b and 8c, said bit sequences being able to be temporarily stored in the buffers 7 once a currently measured actual value corresponds to the appropriate nominal value.

In addition or as an alternative, the respective bit sequences can also be stored in the memory 10, which is connected directly to the bus 6 and is expediently in the form of an EEPROM, or can be stored externally in an appropriate memory via the interface 11, so that they can be copied into the respective buffer 7 of the D/A converters 8a, 8b and 8c when the control system according to the invention is restarted. For such a case, provision is additionally made for the microprocessor 9 expediently to control the order of the copying processes.

The control system according to the invention is thus based on the concept of using a single system to tune different analogue electrical parameters using a bus 6, which is freely configurable in accordance with the present illustrative embodiment, as a flexible interface between the respective measurement and control branches and the microprocessor 9, and memories 10 connected thereto and/or external memories which can be connected via interfaces 11. Such a system requires only a minimum number of component parts or components in order to control a multiplicity of parameters whose size could previously be set essentially only individually and/or by means of manual tuning, so that it is possible to dispense with an otherwise necessary multiplicity of local regulating circuits.

The individual system components, such as, in particular, the microprocessor 9, the memory 10 and/or software stored therein, such as, in particular, databases containing nominal values, test routines and/or computer programs which can be used to control the system, can be used jointly, so that the total complexity for tuning or correcting individual electrical parameters is significantly reduced.

In addition, individual control parameters, individual control processes and/or the complete software for the control process can be designed in such a way and/or, depending on the application instance, can be newly set in such a way that, by way of example, the electrical parameters of other or replaced components, or components newly connected to the bus, can also be corrected. In addition, in particular, faulty circuit parts or other types of faults in the entire apparatus can be quickly localized, for example using implemented test routines, or individual parameters which aging and/or extreme operating conditions cause to drift so far that the functions of the entire apparatus are at risk can be corrected as appropriate.

The free configurability of the bus 6 also means that the control system according to the invention is essentially flexible according to the application instance, i.e. can be expanded on a modular basis, in particular.

The individual measuring arrangements which are to be provided, particularly for detecting the electrical parameters, and are inherently in the area of knowledge and ability of a person skilled in the art who has become established in this area, and which are therefore not described in detail, may also be in the form of integrated circuits, the invention also covering embodiments in which the entire control system according to the invention is in the form of an integrated circuit.

The inventive system integrated in a complex entire apparatus, such as a transceiver, can thus be used to carry out tuning operations under real conditions. These include, in particular, tuning operations in housings which are impervious to radio frequency, or under extreme temperature conditions, and such operations can in principle be carried out more accurately than previously because there is essentially no longer any need to have recourse to prescribed series of resistance standards, but rather access to intermediate values is made possible.

Even in the case of partial or constant monitoring by a person, this person, particularly when the interface 11 is in the form of a radio interface, need no longer be present directly at the site of the entire apparatus to be checked, which means that this also achieves a significant simplification of the operations involving personnel, particularly for operational monitoring.

## Claims

1. System for controlling electrical parameters of circuit components in electrical and/or electronic apparatuses, comprising:
- at least one device (1a, 1b, 1c, 1d, 4), respectively allocated to each parameter which is to be controlled, for measuring the parameter,
- at least one device (8a, 8b, 8c), respectively allocated to each parameter which is to be controlled, for supplying a controlled variable,
- the at least one measuring device (1a, 1b, 1c, 1d, 4) and at least one device (8a, 8b, 8c) for supplying the controlled variable being connected via a common bus (6) to a control device (9) which drives the associated device (8a, 8b, 8c) for supplying the controlled variable on the basis of a measured parameter.

2. System according to Claim 1, **characterized in that** the control device is in the form of a programmable processor (9).

3. System according to Claim 1 or 2, **characterized in that** the control device (9) compares a measured parameter with a prescribable nominal value.

4. System according to one of Claims 1 to 3, **characterized in that** the measuring device comprises an A/D converter (4), and the device for supplying the controlled variable comprises a D/A converter (8a, 8b, 8c).

5. System according to one of Claims 1 to 4, **characterized in that** the measuring device (1a, 1b, 1c, 1d, 4) and the supplying device (8a, 8b, 8c) have associated buffers (5, 7).

6. System according to one of Claims 1 to 5, **characterized in that** the bus (6) is essentially freely configurable.

7. System according to one of Claims 1 to 6, **characterized by** at least one memory device (10) connected to the bus (6).

8. System according to one of Claims 1 to 7, **characterized by** at least one interface (11), connected to the bus (6), for connecting external components, in particular wirelessly.

9. System according to one of Claims 1 to 8, **characterized in that** all or part of the system is in the form of an integrated circuit.

10. Computer program for controlling a system according to one of Claims 1 to 9.
